# EUROPEAN PATENT APPLICATION

(11) **EP 4 080 550 A1**
(43) Date of publication of application: **26.10.2022**
(21) Application number: 20903031.1
(22) Date of filing: 16.12.2020
(51) Int. Cl.: H01L 21/52, H01L 21/683, H01L 21/67, H01L 21/677, H01L 25/075, H01L 27/12, H01L 25/16

(54) **MICRO-LED TRANSFER METHOD AND MICRO-LED TRANSFER APPARATUS**

(30) Priority: 18.12.2019 US 201962949701 P; 15.12.2020 US 202017122995
(71) Applicant: Seoul Viosys Co., Ltd, Ansan-si, Gyeonggi-do 15429 (KR)
(72) Inventor: YOU, Ik Kyu, Ansan-si Gyeonggi-do 15429 (KR); LEE, Jung Jae, Ansan-si Gyeonggi-do 15429 (KR)
(74) Representative: Isarpatent
(86) International application number: PCT/KR2020/018414
(87) International publication number: WO 2021/125775

(57) **Abstract**

A micro-LED transfer method according to one embodiment comprises: preparing a substrate on which a plurality of micro-LEDs are formed; transferring the plurality of micro-LEDs onto a first carrier substrate having a first adhesive material layer; curing the first adhesive material layer, thereby reducing the adhesive strength of the first adhesive material layer; transferring the plurality of micro-LEDs, which are placed on the first carrier substrate, onto a second carrier substrate having a second adhesive material layer; bonding at least some of the plurality of micro-LEDs, which are placed on the second carrier substrate, to pads on a circuit board by using a metal bonding layer; and separating the second carrier substrate from the micro-LEDs bonded onto the circuit board.

## Description

### [TECHNICAL FIELD]

Exemplary embodiments relate to a method of transferring micro LEDs and a micro LED transferring apparatus.

### [Related Art]

As an inorganic light source, light emitting diodes have been used in various fields including displays, vehicular lamps, general lighting, and the like. With various advantages of the light emitting diodes over conventional light sources, such as longer lifespan, lower power consumption, and rapid response, light emitting diodes have been replacing coventional light sources.

Meanwhile, conventional light emitting diodes have been mainly used as backlight light sources in display apparatuses. However, recently, LED display apparatuses that directly display an image using small-sized light emitting diodes, such as micro LEDs, have been developed.

In general, a display apparatus realizes various colors through mixture of blue, green and red light. In order to display various images, the display apparatus includes a plurality of pixels, each including sub-pixels corresponding to blue, green and red light, respectively, in which a color of a certain pixel is determined based on the colors of the sub-pixels so that images can be displayed through combination of such pixels.

LEDs can emit light of various colors depending on their materials, and a display apparatus in which individual micro LEDs emitting blue, green, and red are arranged on a two-dimensional plane, or a display apparatus in which micro LEDs having a stacked structure in which a blue LED, a green LED, and a red LED are stacked one above another are arranged on a two-dimensional plane may be provided.

Micro LEDs used in one display apparatus usually require more than one million even for a small-sized display. Due to the small size of micro LEDs and the enormous number required, mass production of micro LED display apparatus with a conventional technology is almost impossible since the conventional die bonding technology mounts LED chips individually. Accordingly, a technology for transferring a plurality of micro LEDs onto a circuit board in a group has been recently developed. For example, a plurality of micro LEDs formed on a wafer may be transferred onto the circuit board using a technique such as selective laser lift-off.

However, transferring micro LEDs to specific locations of the circuit board in a group may be very difficult due to a difference in thermal expansion coefficients between the wafer and the circuit board.

### [Disclosure]

### [Technical Problem]

Exemplary embodiments provide a method of transferring micro LEDs and a micro LED transferring apparatus.

### [Technical Solution]

A method of transferring micro LEDs according to an exemplary embodiment includes: preparing a substrate on which a plurality of micro LEDs is formed; transferring the plurality of micro LEDs onto a first carrier substrate having a first adhesive material layer; reducing an adhesiveness of the first adhesive material layer by curing the first adhesive material layer; transferring the plurality of micro LEDs on the first carrier substrate onto a second carrier substrate having a second adhesive material layer; bonding at least a portion of the plurality of micro LEDs on the second carrier substrate to pads on the circuit board using a metal bonding layer; and separating the second carrier substrate from the micro LEDs bonded onto the circuit board.

A micro LED transferring apparatus according to an exemplary embodiment includes: a loading device configured to load a wafer which micro LEDs are formed on and is divided into a plurality of wafer sections; a transport device configured to pick up the wafer section from the wafer moved from the loading device and transpor the wafer section to a first adhesive material layer on a first carrier substrate; a laser irradiation device configured to irradiate a laser to the wafer section; a substrate separation device configured to separate a substrate from the micro LEDs; a curing device configured to cure the first adhesive material layer; and a pickup device configured to pick up micro LEDs from the first carrier substrate using a second carrier substrate having a second adhesive material layer.

A method of transferring a plurality of micro LEDs formed on a substrate according to still another exemplary embodiment includes transferring the micro LEDs from the substrate to a first carrier substrate on which a first material layer having a first adhesiveness is formed, transferring the micro LEDs from the first carrier substrate to a second carrier substrate on which a second material layer having a second adhesiveness is formed, and selectively transferring a portion of the micro LEDs from the second carrier substrate to a circuit board on which a third material layer having a third adhesiveness is formed, in which the third adhesiveness is greater than the second adhesiveness, and the second adhesiveness is greater than the first adhesiveness.

### [Description of Drawings]

FIG. 1 is a schematic plan view illustrating a wafer on which micro LEDs are formed.
FIG. 2 is a schematic cross-sectional view illustrating a divided section in the wafer of FIG. 1.
FIGS. 3, 4, 5, 6, 7, and 8 are schematic cross-sectional views illustrating a method of transferring micro LEDs onto a circuit board according to an exemplary embodiment.
FIG. 9 is a schematic cross-sectional view illustrating a display panel according to an exemplary embodiment.
FIG. 10 is a schematic diagram illustrating a micro LED transferring apparatus according to an exemplary embodiment.
FIG. 11 is a schematic diagram illustrating a micro LED transferring apparatus according to another exemplary embodiment.

### [Detailed Description of the Illustrated exemplary embodiments]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of devices can be exaggerated for clarity and descriptive purposes. When an element or layer is referred to as being "disposed above" or "disposed on" another element or layer, it can be directly "disposed above" or "disposed on" the other element or layer or intervening devices or layers can be present. Throughout the specification, like reference numerals denote like devices having the same or similar functions.

A method of transferring micro LEDs according to an exemplary embodiment includes: preparing a substrate on which a plurality of micro LEDs is formed; transferring the plurality of micro LEDs onto a first carrier substrate having a first adhesive material layer; reducing an adhesiveness of the first adhesive material layer by curing the first adhesive material layer; transferring the plurality of micro LEDs on the first carrier substrate onto a second carrier substrate having a second adhesive material layer; bonding at least a portion of the plurality of micro LEDs on the second carrier substrate to pads on the circuit board using a metal bonding layer; and separating the second carrier substrate from the micro LEDs bonded onto the circuit board.

The micro LEDs may be safely transferred by using the second carrier substrate having the second adhesive material layer, instead of directly transferring the micro LEDs from the substrate on which the micro LEDs are formed onto the circuit board,

An adhesiveness of the second adhesive material layer is greater than that of the cured first adhesive material layer, and less than bonding force of the bonding layer.

The first adhesive material layer may be an ultraviolet tape, and the second adhesive material layer may be a highly heat-resistant tape.

The first adhesive material layer may be cured by irradiating an ultraviolet ray.

In an exemplary embodiment, the ultraviolet ray may be limitedly irradiated to regions to which the micro LEDs are attached.

The adhesiveness of the first adhesive material layer may be reduced to 1/100 or less by curing.

Meanwhile, a difference between a thermal expansion coefficient of the second carrier substrate and that of the circuit board may be less than 10% of the thermal expansion coefficient of the circuit board. Since the second carrier substrate having the thermal expansion coefficient similar to that of the circuit board is used, occurrence of bonding failures during bonding of micro LEDs may be prevented.

A micro LED transferring apparatus according to an exemplary embodiment includes: a loading device for loading a wafer which micro LEDs are formed on and is divided into a plurality of wafer sections; a transport device for picking up the wafer section from the wafer moved from the loading device and transporting the wafer section to a first adhesive material layer on a first carrier substrate; a laser irradiation device for irradiating a laser to the wafer section; a substrate separation device for separating a substrate from the micro LEDs; a curing device for curing the first adhesive material layer; and a pickup device for picking up micro LEDs from the first carrier substrate using a second carrier substrate having a second adhesive material layer.

In an exemplary embodiment, the transferring apparatus may further include an unloading device for unloading the second carrier substrate that picked up the micro LEDs.

The pickup device may bond at least a portion of the micro LEDs picked up by the second carrier substrate onto a circuit board, and separate the second carrier substrate from the bonded micro LEDs.

In an exemplary embodiment, the transferring apparatus may further include an unloading device for unloading the circuit board to which the micro LEDs are bonded.

The transferring apparatus may further include a bonding device, in which the bonding device may bond at least a portion of the micro LEDs picked up by the second carrier substrate onto the circuit board, and separate the second carrier substrate from the bonded micro LEDs.

Meanwhile, the first adhesive material layer may be an ultraviolet tape, and the second adhesive material layer may be a highly heat-resistant tape.

The curing device may cure the first adhesive material layer by irradiating an ultraviolet ray.

In an exemplary embodiment, the ultraviolet ray may be limitedly irradiated to regions to which the micro LEDs are attached.

A method of transferring a plurality of micro LEDs formed on a substrate according to still another exemplary embodiment includes transferring the micro LEDs from the substrate to a first carrier substrate on which a first material layer having a first adhesiveness is formed, transferring the micro LEDs from the first carrier substrate to a second carrier substrate on which a second material layer having a second adhesiveness is formed, and selectively transferring a portion of the micro LEDs from the second carrier substrate to a circuit board on which a third material layer having a third adhesiveness is formed, in which the third adhesiveness is greater than the second adhesiveness, and the second adhesiveness is greater than the first adhesiveness.

The first adhesiveness may be changed after removing the substrate from the micro LEDs.

Transferring the micro LEDs from the substrate to the first carrier substrate may include irradiating a laser in a first direction, transferring the micro LEDs from the first carrier substrate to the second carrier substrate may include irradiating ultraviolet light in a second direction opposite to the first direction, and selectively transferring the portion of the micro LEDs may include applying heat.

The first carrier substrate may transmit ultraviolet light.

A difference between a thermal expansion coefficient of the second carrier substrate and a thermal expansion coefficient of the circuit board may be less than 10% of a thermal expansion coefficient of the circuit board

Hereinafter, exemplary embodiments of the inventive concepts will be described in detail with reference to the accompanying drawings.

Micro LEDs according to exemplary embodiments are not particularly limited, but particularly, may be used in a VR display apparatus such as a smart watch, a VR headset, or an AR display apparatus such as an augmented reality glasses. In these display apparatuses, a display panel on which micro LEDs are mounted may be employed to display an image. After the micro LEDs are formed on a wafer, the micro LEDs are transferred to a circuit board, so that the display panel can be manufactured. Hereinafter, a method of transferring micro LEDs will be described in detail.

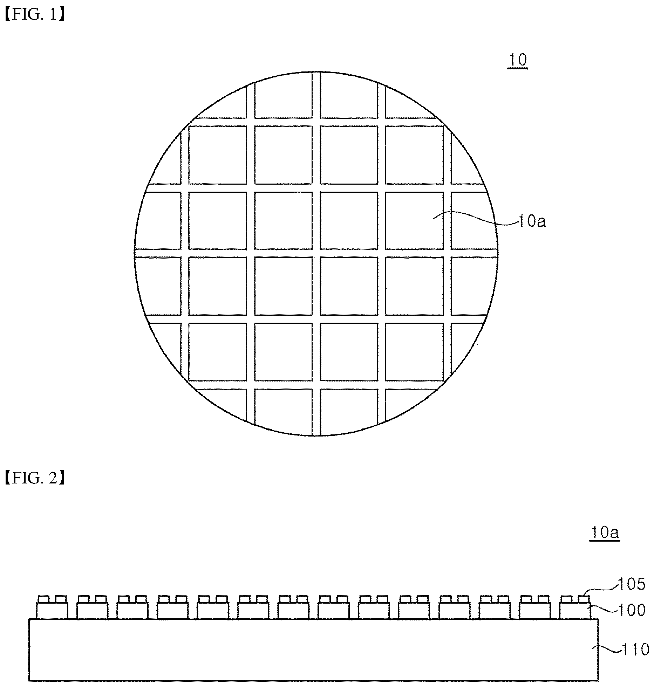

First, FIG. 1 is a schematic plan view illustrating a wafer 10 on which micro LEDs are formed, and FIG. 2 is a schematic cross-sectional view illustrating a divided section 10a in the wafer of FIG. 1.

Referring to FIGS. 1 and 2, to transfer micro LEDs 100 to a desired region of a display panel, a wafer on which the micro LEDs 100 are formed may be divided (or singularized) into a plurality of sections 10a. FIG. 2 is a cross-sectional view of the divided section 10a. The micro LEDs 100 may be formed on a substrate 110, and the substrate 110 is divided together when the wafer 10 is divided. The micro LEDs 100 may be transferred using the divided section 10a. Since the divided section 10a is small in size, bowing thereof may be reduced compared to the wafer 10. The substrate 110 may be a growth substrate for capable of growing an epitaxial layer thereon, for example, a sapphire substrate, a GaAs substrate, a silicon substrate, a GaN substrate, or a SiC substrate, or the like, but the inventive concepts are not limited thereto.

The micro LED 100 may have, for example, a size smaller than 500um×500um, and further, smaller than 100um×100um. A structure of the micro LED 100 is not particularly limited. In an exemplary embodiment, the micro LED 100 may be employed as a sub-pixel that emits light of a specific color, and these sub-pixels may form one pixel. For example, a blue micro LED, a green micro LED, and a red micro LED may be disposed adjacent to one another to form one pixel. Micro LEDs emitting light of a specific color may be formed on one wafer 10. In another exemplary embodiment, each of the micro LEDs 100 may have a stacked structure that emits light of various colors. For example, each of the micro LEDs 100 may have a stacked structure, in which a blue LED, a green LED, and a red LED are overlapped with one another, and thus, one micro LED 100 may form one pixel.

The micro LEDs 100 may have pads 105, and the pads 105 may be adhered to corresponding pads of a circuit board through a bonding layer.

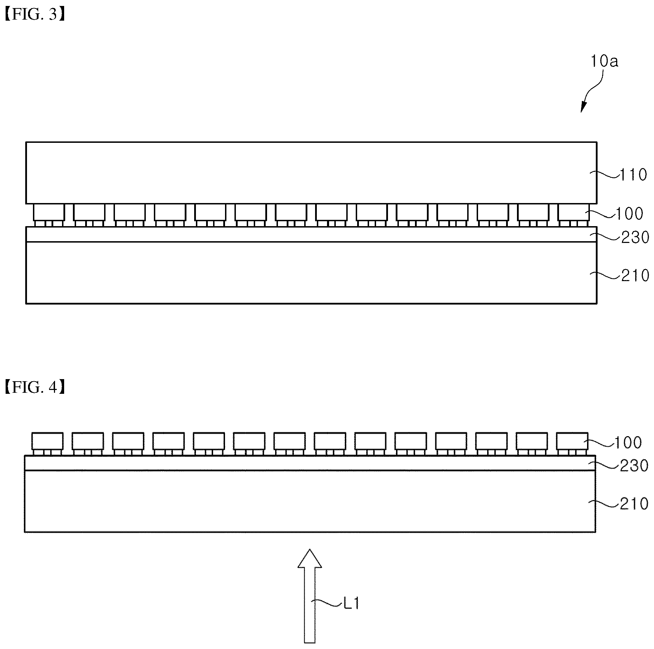

FIGS. 3, 4, 5, 6, 7, and 8 are schematic cross-sectional views illustrating a method of transferring micro LEDs onto a circuit board according to an exemplary embodiment.

Referring to FIG. 3, a first carrier substrate 210 having one surface with a first adhesive material layer 230 is provided. For example, the first adhesive material layer 230 may be a double-sided tape. The first adhesive material layer 230 may be a material layer that may change adhesiveness by curing. The first adhesive material layer 230 may be a material layer that have a reduced adhesiveness after curing, such as an ultraviolet (UV) tape. The ultraviolet tape may be cured by UV irradiation, and an adhesiveness thereof is reduced to about 1/100 or less, further to about 1/200 or less when cured. For example, adhesion of the first adhesive material layer 230 may be about 100 gf/mm before curing, which may be reduced to 0.5 gf/mm after curing.

The first carrier substrate 210 may be a light-transmitting substrate. The material of the first carrier substrate 210 is not particularly limited. In an exemplary embodiment, the first carrier substrate 210 may be formed of a material having the same or similar thermal expansion coefficient as the substrate 110. For example, when the substrate 110 is a sapphire substrate, the first carrier substrate 210 may also be a sapphire substrate. The first carrier substrate 210 may be as thick as, or thicker than the substrate 110. When the first carrier substrate 210 is thicker than the substrate 110, the micro LEDs 100 that have been transferred may be more stably held, and furthermore, the first carrier substrate 210 may be prevented from or at least be suppressed from bending.

The micro LEDs 100 of in the divided section 10a are attached on the first adhesive material layer 230 before curing. Each of the micro LEDs 100 on the substrate 110 may be attached to the first adhesive material layer 230.

Subsequently, the substrate 110 is removed from the micro LEDs 100 using a technique such as laser lift off (LLO), or the like. The first adhesive material layer 230, such as UV tape, may prevent locations of the micro LEDs 100 from being changed while the substrate 110 is separated using the laser lift-off.

Referring to FIG. 4, after the substrate 110 is removed, the first adhesive material layer 230 is cured. For example, the first adhesive material layer 230 may be cured using UV light L1. Adhesiveness of the first adhesive material layer 230 may be reduced by curing.

UV light L1 may be irradiated from a lower portion of the first carrier substrate 210, and thus, the first carrier substrate 210 needs to be formed of a material that transmits UV. UV light L1 is irradiated to the first adhesive material layer 230 to which the micro LEDs 100 are attached. UV light L1 may be simultaneously irradiated or continuously irradiated to a plurality of micro LEDs 100.

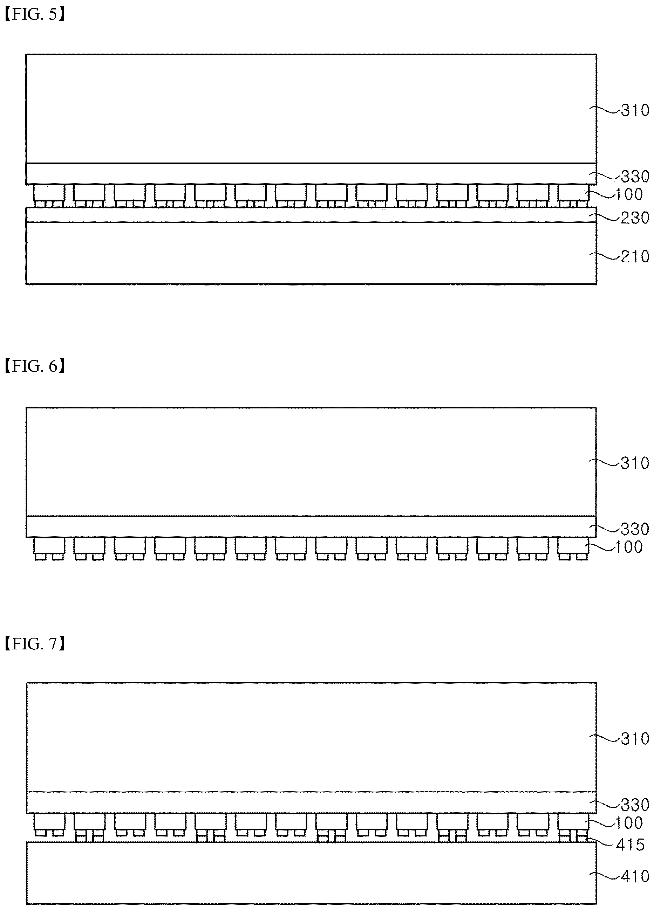

Referring to FIG. 5, the micro LEDs 100 are attached to a second carrier substrate 310 having a second adhesive material layer 330. In addition, the second adhesive material layer 330 has an adhesiveness greater than that of the first adhesive material layer 230 after curing. Furthermore, the second adhesive material layer 330 may have and adhesiveness greater than that of the first adhesive material layer 230 before curing. For example, the second adhesive material layer 330 may be a highly heat-resistant tape. The highly heat-resistant tape may safely hold the micro LEDs 100 while the micro LEDs 100 are bonded. The second adhesive material layer 330 may have an adhesiveness of about 20 gf/mm, and may be, for example, a material layer that is stable at a temperature of 180°C or higher, further 280°C or higher, and furthermore 300°C or higher.

The second carrier substrate 310 is not particularly limited. However, the second carrier substrate 310 may be selected in consideration of a thermal expansion coefficient of the circuit board to which the micro LEDs 100 are to be transferred. In a case that the thermal expansion coefficient of the second carrier substrate 310 is the same as or similar to that of the circuit board, locations of the micro LEDs may be prevented from being changed when the micro LEDs 100 are bonded onto the circuit board using a high temperature process such as solder bonding.

Referring to FIG. 6, the first carrier substrate 210 and the first adhesive material layer 230 are removed from the micro LEDs 100. The first adhesive material layer 230 has a considerably weaker adhesiveness than the second adhesive material layer 330 when cured, and thus, the first adhesive material layer 230 may be easily removed from the micro LEDs 100 using physical force.

Referring to FIG. 7, at least a portion of the micro LEDs 100 attached to the second carrier substrate 310 is bonded onto a circuit board 410. The circuit board 410 may include a circuit for passive matrix driving or active matrix driving. In an exemplary embodiment, the circuit board 410 may include interconnection lines and a resistor therein. In another exemplary embodiment, the circuit board 410 may include interconnection lines, transistors, and capacitors. For example, the circuit board 410 may be a glass substrate including a thin film transistor. The circuit board 410 may also have pads 415 disposed on an upper surface thereof to allow electrical connection to the circuit therein. The pads 415 may be disposed in each region to which the micro LEDs 100 are to be transferred, and the micro LEDs 100 may be bonded to the pads 415 using a metal bonding material such as AuSn, CuSn, or In.

The micro LEDs 100 arranged on the second carrier substrate 310 may be more densely arranged than the micro LEDs 100 arranged on the circuit board 410, and thus, a portion of the micro LEDs 100 on the second carrier substrate 310 may be selectively transferred to the circuit board 410. As such, a distance between the micro LEDs 100 transferred onto the circuit board 410 may be greater than a width of the micro LED 100.

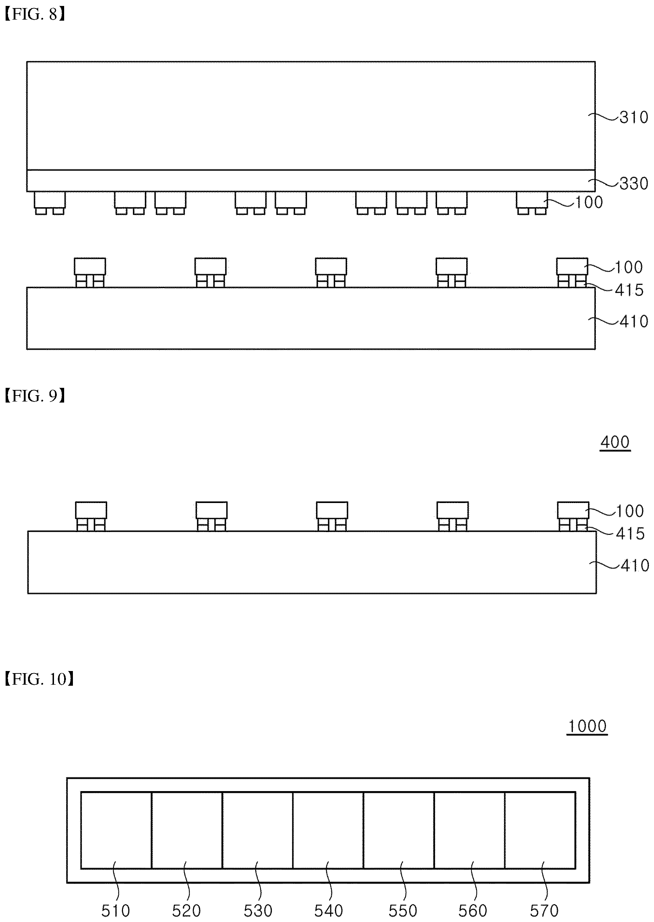

After the micro LEDs 100 are bonded to the pads 415 on the circuit board 410, the second carrier substrate 310 is separated from the circuit board 410. Bonding force of the micro LEDs 100 by metal bonding is greater than bonding force by the second adhesive material layer 330, and thus, the micro LEDs 100 bonded to the pads 415 are transferred to the circuit board 410. As such, as shown in FIG. 9, a display panel 400 in which the micro LEDs 100 are arranged on the circuit board 410 may be provided.

Meanwhile, other micro LEDs 100 that are not bonded to the pads 415 of the circuit board 410 may be retained on the second carrier substrate 310 by the second adhesive material layer 330. These micro LEDs 100 may be transferred onto another circuit board through the manufacturing process described above.

When the micro LEDs 100 are bonded onto the circuit board 410 using a metal bonding layer, heat is applied to the circuit board 410 and the second carrier board 310. When a difference in thermal expansion coefficient between the circuit board 410 and the second carrier board 310 is large, bonding failure of the micro LEDs 100 may occur. As such, the second carrier substrate 310 may be selected in consideration of the thermal expansion coefficient of the circuit board 410. For example, the difference between the thermal expansion coefficient of the second carrier substrate 310 and that of the circuit board 410 may be less than 10% of the thermal expansion coefficient of the circuit board 410.

FIG. 10 is a schematic diagram illustrating a micro LED transferring apparatus 1000 according to an exemplary embodiment.

Referring to FIG. 10, the micro LED transferring apparatus 1000 may include a loading device 510, a transport device 520, a laser irradiation device 530, a substrate separation device 540, a curing device 550, a pickup and bonding device 560, and an unloading device 570.

The loading device 510 is used to load the wafer 10 described in FIG. 1. The wafer 10 may be loaded into the loading device 510 while being divided into a plurality of sections 10a. For example, the wafer 10 may be formed with scribing lines that cross each other by which the sections 10a may be defined. In this case, while each section 10a may be defined in the wafer 10, the sections 10a may not be individualized from the wafer 10 to facilitate the loading process and handling of multiple sections 10a. In some exemplary embodiments, a plurality of wafers 10 may be mounted on a cassette and loaded into the loading device 510. The wafers 10 loaded in the loading device 510 may be sequentially transferred to the transport device 520.

The transport device 520 separates the wafer section 10a from the wafer 10 that has been moved from the loading device 510, and transports the wafer section 10a to a first adhesive material layer 230 of a first carrier substrate (210 in FIG. 3). A plurality of first carrier substrates 210 having the first adhesive material layer 230 may be stored in the transport device 520. One of the first carrier substrates 210 stored in the transport device 520 is selected, and the wafer section 10a is attached onto the first carrier substrate 210. The first carrier substrate 210 to which the wafer section 10a is attached may be moved to the laser irradiation device 530.

The laser irradiation device 530 separates the micro LEDs 100 from a substrate 110 by irradiating a laser through the substrate 110. This process is known as laser lift off. The laser may be irradiated to each region of the micro LEDs 100 through the substrate 110.

The substrate separation device 540 separates the substrate 110 from the micro LEDs 100 on which the laser lift-off process has been performed. The substrate 110 may be collected at the substrate separation device 540, and may be removed from the substrate separation device 540 after a plurality of substrates 110 is collected. After the substrate 110 is separated, the first carrier substrate 210 is moved to the curing apparatus 550 along with the micro LEDs 100.

The curing device 550 cures the first adhesive material layer 230. The curing device 550 may cure the first adhesive material layer 230 using, for example, UV. UV may be irradiated to the first adhesive material layer 230 through the first carrier substrate 210. UV may be irradiated on an entire surface of the first adhesive material layer 230, but the inventive concepts are not limited thereto, and may be limitedly irradiated to regions of the first carrier substrate 210 to which the micro LEDs 100 are attached. The adhesiveness of the first adhesive material layer 230 may be reduced by curing. After the first adhesive material layer 230 is cured, the first carrier substrate 210 is moved to the pickup and bonding device 560.

In the pickup and bonding apparatus 560, a second carrier substrate 310 having a second adhesive material layer 330 is stored. The second carrier substrate 310 picks up the micro LEDs 100 from the first carrier substrate 210 using the second adhesive material layer 330. The second carrier substrate 310 from which the micro LEDs 100 are separated is collected in the pickup and bonding device 560 and removed.

Meanwhile, the circuit board 110 may also be stored in the pickup and bonding device 560, and at least a portion of the micro LEDs 100 picked up by the second carrier board 310 is bonded to pads 415 of a circuit board 410. The second carrier substrate 310 is spaced apart from the circuit board 410.

The circuit board 410 to which the micro LEDs 100 are bonded is moved to the unloading device 570. Meanwhile, the micro LEDs 100 remaining on the second carrier substrate 310 may be bonded to another circuit board, and after the micro LEDs 100 are transferred to the circuit board, the second carrier substrate 310 may be collected in the bonding device 560 and removed.

The unloading device 570 unloads a display panel 400 in which the micro LEDs 100 are arranged on the circuit board 410.

In the illustrated exemplary embodiment, the loading device 510, the transport device 520, the laser irradiation device 530, the substrate separation device 540, the curing device 550, the pickup and bonding device 560, and the loading device 570 may be arranged in-line. As such, the micro LEDs may be continuously transferred from the wafer 10 to the circuit board 410 using the transferring apparatus 1000 of the illustrated exemplary embodiment.

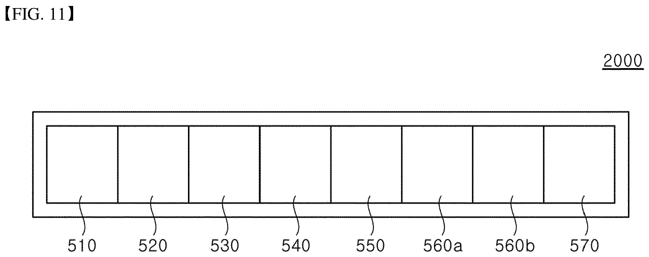

FIG. 11 is a schematic diagram illustrating a micro LED transferring apparatus 2000 according to another exemplary embodiment.

Referring to FIG. 11, the transferring apparatus 2000 according to the exemplary embodiment is substantially similar to the transferring apparatus 1000 described above, but a pickup and bonding device 560 is divided so as to include a pickup device 560a and a bonding device 560b.

After a first adhesive material layer 230 is cured, a first carrier substrate 210 is moved to the pickup device 560a. A second carrier substrate 310 having a second adhesive material layer 330 is stored in the pickup device 560a. The second carrier substrate 310 picks up micro LEDs 100 on the first carrier substrate 210 using the second adhesive material layer 330. The second carrier substrate 310 from which the micro LEDs 100 are separated may be collected in the pickup device 560a and removed. Meanwhile, the second carrier substrate 310 that picked up the micro LEDs 100 is moved to the bonding device 560b.

A circuit board 110 is stored in the bonding device 560b, and at least a portion of the micro LEDs 100 picked up by the second carrier board 310 is bonded to pads 415 on a circuit board 410. Thereafter, the second carrier substrate 310 is separated from the circuit board 410 and the micro LEDs 100 are transferred onto the circuit board 410.

The circuit board 410 to which the micro LEDs 100 are bonded is moved to an unloading device 570. Meanwhile, the micro LEDs 100 remaining on the second carrier substrate 310 may be bonded to another circuit board, and after the micro LEDs 100 are moved to the circuit board, the second carrier substrate 310 may be collected in the bonding device 560b and removed.

According to the illustrated exemplary embodiment, by separating the pickup device 560a and the bonding device 560b, the transferring process of the micro LEDs may be performed fast.

Meanwhile, although it is exemplarily described that a display panel 400 is manufactured in the transferring apparatus 2000, the display panel 400 may be manufactured outside of the transferring apparatus 2000, and the unloading device 570 may unload the second carrier substrate 310 that picked up the micro LEDs. As such, the bonding device 560b may be omitted.

Although certain exemplary embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A method of transferring micro LEDs, comprising:
preparing a substrate on which a plurality of micro LEDs is formed;
transferring the plurality of micro LEDs onto a first carrier substrate having a first adhesive material layer;
reducing an addhesiveness of the first adhesive material layer by curing the first adhesive material layer;
transferring the plurality of micro LEDs on the first carrier substrate onto a second carrier substrate having a second adhesive material layer;
bonding at least a portion of the plurality of micro LEDs on the second carrier substrate to pads of a circuit board using a metal bonding layer; and
separating the second carrier substrate from the micro LEDs bonded onto the circuit board.

2. The method of transferring micro LEDs of claim 1,
wherein an adhesiveness of the second adhesive material layer is greater than that of the cured first adhesive material layer and less than bonding force of the bonding layer.

3. The method of transferring micro LEDs of claim 1, wherein:
the first adhesive material layer is an ultraviolet tape, and
the second adhesive material layer is a highly heat-resistant tape.

4. The method of transferring micro LEDs of claim 3,
wherein the first adhesive material layer is cured by irradiating an ultraviolet ray.

5. The method of transferring micro LEDs of claim 4,
wherein the ultraviolet ray is limitedly irradiated to regions to which the micro LEDs are attached.

6. The method of transferring micro LEDs of claim 1,
wherein the adhesiveness of the first adhesive material layer is reduced to 1/100 or less by curing.

7. The method of transferring micro LEDs of claim 1,
wherein a difference between a thermal expansion coefficient of the second carrier substrate and that of the circuit board is less than 10% of the thermal expansion coefficient of the circuit board.

8. A micro LED transferring apparatus, comprising:
a loading device configured to load a wafer which micro LEDs are formed on and divided into a plurality of wafer sections;
a transport device configured to pick up the wafer section from the wafer moved from the loading device and transpor the wafer section to a first adhesive material layer on a first carrier substrate;
a laser irradiation device configured to irradiate a laser to the wafer section;
a substrate separation device configured to separate a substrate from the micro LEDs;
a curing device configure to cure the first adhesive material layer; and
a pickup device configured to pick up micro LEDs from the first carrier substrate using a second carrier substrate having a second adhesive material layer.

9. The micro LED transferring apparatus of claim 8, further comprising:
an unloading device configured to unload the second carrier substrate that picked up the micro LEDs.

10. The micro LED transferring apparatus of claim 8,
wherein the pickup device is configured to bond at least a portion of the micro LEDs picked up by the second carrier substrate onto a circuit board, and to separate the second carrier substrate from the bonded micro LEDs.

11. The micro LED transferring apparatus of claim 10, further comprising:
an unloading device configured to unload the circuit board onto which the micro LEDs are bonded.

12. The micro LED transferring apparatus of claim 8, further comprising:
a bonding device,
the bonding device,
bonding at least a portion of the micro LEDs picked up by the second carrier substrate onto the circuit board, and
separating the second carrier substrate from the bonded micro LEDs.

13. The micro LED transferring apparatus of claim 8, wherein:
the first adhesive material layer is an ultraviolet tape, and
the second adhesive material layer is a highly heat-resistant tape.

14. The micro LED transferring apparatus of claim 8,
wherein the curing device cures the first adhesive material layer by irradiating an ultraviolet ray.

15. The micro LED transferring apparatus of claim 14,
wherein the ultraviolet ray is limitedly irradiated to regions to which the micro LEDs are attached.

16. A method of transferring a plurality of micro LEDs formed on a substrate, comprising:
transferring the micro LEDs from the substrate to a first carrier substrate on which a first material layer having a first adhesiveness is formed;
transferring the micro LEDs from the first carrier substrate to a second carrier substrate on which a second material layer having a second adhesiveness is formed;
selectively transferring a portion of the micro LEDs from the second carrier substrate to a circuit board on which a third material layer having a third adhesiveness is formed,
wherein the third adhesiveness is greater than the second adhesiveness, and the second adhesiveness is greater than the first adhesiveness.

17. The method of claim 16, wherein the first adhesiveness is changed after removing the substrate from the micro LEDs.

18. The method of claim 16, wherein:
transferring the micro LEDs from the substrate to the first carrier substrate includes irradiating a laser in a first direction;
transferring the micro LEDs from the first carrier substrate to the second carrier substrate includes irradiating ultraviolet light in a second direction opposite to the first direction; and
selectively transferring the portion of the micro LEDs includes applying heat.

19. The method of claim 16, wherein the first carrier substrate transmits ultraviolet light.

20. The method of claim 16, wherein a difference between a thermal expansion coefficient of the second carrier substrate and a thermal expansion coefficient of the circuit board is less than 10% of a thermal expansion coefficient of the circuit board.
